# EUROPEAN PATENT APPLICATION

(11) **EP 2 423 158 A1**
(43) Date of publication of application: **29.02.2012**
(21) Application number: 11176757.0
(22) Date of filing: 24.03.2005
(51) Int. Cl.: B81C 1/00, C30B 23/00, C30B 25/00, C23C 14/16, C23C 14/54, C30B 29/02

(54) **Methods of forming alpha and beta tantalum films with controlled and new microstructures**

(30) Priority: 24.03.2004 US 555759 P
(62) Divisional of application: 05729297.1
(71) Applicant: H. C. Starck Inc, Newton, MA 02461 (US); North Carolina State University, Raleigh, North Carolina 27606 (US)
(72) Inventor: Narayan, Jagdish, Raleigh, NC North Carolina 27613 (US); Kumar, Prabhat, Framingham, MA Massachusetts 01701 (US); Wu, Richard, Chelmsford, MA Massachusetts 01824 (US)
(74) Representative: Maiwald, Walter

(57) **Abstract**

The present invention relates to a tantalum film and a method of forming the same, wherein the tantalum film has an amorphous microstructure characterized by a diffuse x-ray diffraction peak at 2θ= 30-35° and a diffuse ring in the electron diffraction pattern, wherein the tantalum film preferably has no grain boundaries.

## Description

### Field of the Invention

The present invention relates to tantalum films having novel microstructures which provide improved resistance to diffusion. Specifically, single crystal, nanocrystalline and amorphous tantalum films are provided. Such films are useful in microelectronic applications which require a diffusion barrier between a copper interconnect and a silicon substrate. Methods of depositing such films on a substrate, and articles having a tantalum barrier film are also described.

### Background of the Invention

Copper metal (Cu) has attracted considerable attention as an interconnect layer in silicon microelectronic devices because of its low resistivity (1. 67µΩcm for bulk) and its high resistance against electromigration and stress migration. O. Olowolafe, J. Li, J. W. Mayer : J. Appl. Physics., 68 (12), 6207 (1990); S. P. Murarka, Mater. Sci. Eng., R. 19,87 (1997). However, the high diffusivity (D ∼10⁻⁸ cm²/s) of Cu into silicon makes it a fatal impurity, which reduces the minority carrier lifetime in silicon microelectronic devices. S. P. Murarka, Mater. Sci. Eng., R. 19, 87 (1997). All journal articles and issued patents cited to in any portion of this patent are expressly incorporated herein by reference.

Therefore, a thin diffusion barrier preventing Cu diffusion into silicon is required to integrate Cu as an interconnect layer. Ta is one of the most promising diffusion barrier materials for Cu metallization due to its relatively high melting temperature (3287°C) and high activation energy for lattice diffusion, around 4.8eV in bulk Ta. In addition, Ta is thermodynamically stable with respect to Cu as it is almost completely immiscible up to its melting point and does not react to produce any compounds. A. E. Kaloyeros and E.. Eisenbraun, Annu. Rev. Mater. Sci. 30, 363 (2000); Massalski TB. 1990. Binary Phase Diagram. Westerville, OH: Am. SOC. Met.

The reaction between Si and Ta requires temperatures as high as 650°C, G. Ottaviani. Thin Solid Films 140 (1985), p. 3., rendering Si/Ta interface reasonably stable. Ta films also form a stable oxide (Ta₂O₅ that provides a protective layer for Cu diffusion, improves adhesion to SiO₂ and protects the underlying Cu from oxidation until a Ta layer has been completely transformed into Ta₂O₅. T. Ichikawa, M. Takeyama, A. Noya, Jpn. J. Appl. Phys., Part 1 35, 1844 (1996).

Tantalum exists as two phases, the low resistivity (15-30 µΩcm) a-phase (also referred to as the bcc or "body centered cubic" phase) and the higher resistivity (150-200 µΩcm) β-phase (tetragonal structure). When Ta is deposited by physical vapor deposition (PVD) methods the (β-phase forms readily. Methods of achieving the α-Ta form are more difficult to reproduce and have been found to require heating the substrate, introduction of low level impurities into the film, and/or the use of specific base layers such as TaN between the dielectric and the Ta.

The microstructure of thin films plays an important role in governing the properties such as diffusion behavior and electrical conductivity. The resistivity of single-crystal α-Ta is expected to be even lower due to lack of grain-boundary scattering. Single-crystal as well as amorphous barrier layers are expected to be more robust diffusion barriers, as they lack grain boundaries which act as short circuit diffusion paths, compared with polycrystalline layers. The grain boundaries provide short circuit or rapid diffusion paths because the activation energy along the grain boundaries is around 2.4 eV (half of that of the bulk lattice diffusion) or less depending upon the grain boundary structure. While single crystal α-Ta layers remain stable with temperature due to absence of grain boundaries and its high melting point, amorphous films are unstable against recrystallization at high temperatures.

To prevent the recrystallization at high temperatures, studies have been done to dope the Ta films with dopants like CeO₂ to achieve amorphous Ta films and were found to be stable up to 800°C but have shown a considerable increase in the resistivity. D. Yoon, K. Baik and S. Lee, J. Vac. Sci. Technol. B. 17 (1) : 174- 81 (1999). Also, low doping with N and O produced nanocrystalline Ta films as diffusion barriers stable up to 600°C. M. Stavrev, D. Fischer, A. Preu, C. Wenzel, N. Mattern 1997, Microelectron. Eng. 33: 269-75; T. Laurila, K. Zeng, J. Molarius, I. Suni, J. K. Kivilahti; J. Appl. Phys., 88, 3377, (2000). To meet the requirement of lower RC delay in the integrated circuits for future generation devices there is a considerable demand for low resistivity barrier layers. S. P. Murarka, Mater. Sci. Eng., R. 19,87 (1997).

Both α-Ta and β-Ta films can be formed having a polycrystalline microstructure. Films having this microstructure are less desirable for use in microelectronic devices because Cu can diffuse along the film at the grain boundaries. Other microstructures of tantalum films, including amorphous (which is neither α-Ta nor β-Ta), nanocrystalline α-Ta, and single crystal α-Ta are expected to provide improved diffusion barrier properties due to the lack of grain boundaries altogether (in the case of single crystal and amorphous). In the case of the nanocrystalline form, the grain boundary is convoluted and the path through the layer is quite tortuous, so that this form can also act as a good diffusion barrier.

Catania, P. et al. ,"Low resistivity body-centered cubic tantalum thin films as diffusion barriers between copper and silicon", J. Vac. Sci. Technol. A 10 (5), Sep/Oct 1992, discloses that ion bombardment during deposition process plays an important role in the growth of the Ta films and that bcc films exhibited no copper-silicon interdiffusion up to 650°C.

Molarius, J. M. T. et al. ,"R. F. -Sputtered tantalum-based diffusion barriers between copper and silicon", Superficies y Vacio 9,206-209, December 1999, discloses the use of rf-sputtering techniques on the formation of tantalum based diffusion barriers.

Donohue, H. G. et al.,"Low-resistivity PVD alpha-tantalum: phase formation and integration in ultra-low k dielectric/copper damascene structures", published by Trikon Technologies, Ringland Way, Newport, NP182TA, UK, discloses the formation of a PVD tantalum diffusion barrier in its low-resistivity alpha-phase in Cu/ultra low-k integration, and describes the mechanism of alpha- Ta phase formation and other film properties.

Kim, H. et al. ,"Diffusion barrier properties of transition metal thin films grown by plasma-enhanced atomic-layer deposition", J. Vac. Sci. Technol. B. 20 (4), Jul/Aug 2002, discloses the growth of beta Ta thin films on Si (001) and polycrystalline Si substrates by plasma-enhanced atomic-layer deposition using TaC15 and atomic hydrogen as precursors. The grown films had a resistivity of 150-180 µΩcm.

U.S. Patent 5, 281, 485 discloses the formation of alpha-tantalum films on a seed layer of Ta (N), using reactive sputtering in a nitrogen environment.

U.S. Patent 6,110, 598 discloses a method of depositing a tantalum film overlaying a tantalum nitride film, where the gas pressure is limited during deposition to produce a tantalum nitride film with a hexagonal crystal structure and a tantalum film having a body-centered cubic (bcc) structure.

U.S. Patent 6,458, 255 discloses the formation of an ultra-low resistivity alpha-and beta-tantalum film using sputter deposition methods and heated substrates.

U.S. Patent 6,794, 338 discloses an article having a substrate and an amorphous layer of a tantalum oxide film thereon.

What is desired is a reproducible and reliable method of forming tantalum films having the desired microstructure which can be used commercially in the production of microelectronic devices.

### Summary of the Invention

Accordingly, in one aspect the present invention provides a tantalum film having a nanocrystalline microstructure as characterized by a broad x-ray diffraction peak at 2θ = 38° and continuous electron diffraction rings.

In an additional aspect, a tantalum film having a single crystal microstructure as characterized by an x-ray diffraction peak at 2θ = 55° and characteristic (100) spot diffraction pattern is provided.

In yet another aspect, the present invention provides a tantalum film having an amorphous microstructure as characterized by a diffuse x-ray diffraction peak at 2θ = 30-35° and a diffuse ring in the electron diffraction pattern.

Methods of depositing the above tantalum films are also provided. In one aspect, the method of forming a tantalum film comprises providing a substrate; optionally, preheating the substrate; providing a vacuum chamber; adjusting the deposition parameters, chamber and substrate parameters as necessary to achieve the desired microstructure; and depositing the tantalum film on the substrate in the

Vacuum chamber at an operating pressure of 10⁻⁴ -10⁻¹⁰ by a method selected from the group consisting of chemical vapor deposition, thermal evaporation, (accelerated) molecular beam epitaxy, atomic-layer deposition, cathodic arc, laser assisted, metal organic, plasma enhanced, sputtering, ion beam deposition and pulsed laser deposition.

In an additional aspect, the invention provides a method of depositing a tantalum film on a substrate comprising energizing the tantalum; depositing the tantalum on a substrate; and quenching the tantalum to kinetically trap the amorphous form at a temperature that formation of crystalline phase is suppressed.

In other aspects, the present invention provides a microelectronic device having a silicon substrate, a tantalum film deposited on the silicon substrate and a copper layer disposed on the tantalum film. In some embodiments, the tantalum film has an amorphous microstructure; in other embodiments, the tantalum film has a nanocrystalline microstructure; in further embodiments, the tantalum film has a single crystal microstructure. Any of these embodiments can further include an additional buffer layer disposed between the substrate and the tantalum layer.

The invention is further illustrated by the following non-limiting drawings, detailed description and appended claims.

### Brief Description of the Drawings

The invention is further illustrated by the following drawings in which:
Figure 1 is a schematic cross-sectional view of formation Ta films **20** on silicon substrate **10** without buffer (Figure 1 (a) ) and with buffer layer **40** (Figure 1 (b) ).
Figure 2 is the XRD (x-ray diffraction) spectra of Ta films deposited on Si (100) substrate by pulsed laser deposition and magnetron sputtering.
Figure 3 is a <110> cross-sectional TEM micrograph of Ta films on Si (100) substrate: (a) low magnification image showing the entire thickness of amorphous layer; (b) high-resolution image with an inset showing the selected-area diffraction pattern of the amorphous phase.
Figure 4 is a scanning electron microscopy (SEM) micrograph of the Ta film surface with inset x-ray EDS (energy dispersive spectroscopy) spectrum.
Figure 5 is (a) a cross-sectional TEM image of the Ta film with the locations of the EELS analysis; (b) EELS spectra corresponding to locations 1,2,3 and 4 in figure (a).
Figure 6 is (a) an X-ray diffraction pattern of the polycrystalline β-Ta films with (002) orientation; (b) High-resolution TEM images for polycrystalline Ta film grown by MS. The inserts are magnified Cu/Ta interface with absence of amorphous Ta₂O₅ and the diffraction pattern of the film.
Figure 7 shows SIMS profiles of Cu/amorphous Ta (PLD)/Si film (a) annealed at ∼650°C for 1 Hr. and (b) as deposited sample. Insignificant diffusion of Cu was observed in the amorphous Ta film. Presence of O and Si was observed in Ta films rendering the amorphisation of Ta films by laser ablation.
Figure 8 shows SIMS profiles of Cu/polycrystalline Ta (MS) /Si film (a) annealed at ∼650°C for 1 Hr. and (b) as deposited sample. Significant diffusion of Cu was observed in polycrystalline Ta film as well in the Si substrate.
Figure 9 is high-resolution TEM images for Ta film grown by PLD and annealed at 700°C ± 30°C for 30 min causing the crystallization of the Ta film.
Figure 10 is (a) a Z contrast image for the amorphous Ta films annealed at ∼ 650°C for 1 Hr. The total diffusion distance is indicated by the arrows. (b) EELS spectrum for showing the presence and Cu and O in the Ta films.
Figure 11 shows electrical resistivity measurements of amorphous Ta (PLD) and polycrystalline Ta (MS), in the temperature range 12°C to 300°C.
Figures 12 (a) and 12 (b) are cross-sectional views of a microelectronic device having a silicon substrate **10** a tantalum layer **20** and a copper layer **30,** with (in 12 (b) ) and without (in 12 (a) ) a buffer layer **40.**

### Detailed Description of Preferred Embodiments

As used herein, except as used in the examples or unless otherwise expressly specified, all numbers may be read as if prefaced by the word "about", even if the term does not expressly appear. Also, any numerical range recited herein is intended to include all sub-ranges subsumed therein.

As used herein, the term "amorphous" means substantially lacking crystalline structure. Also as used herein, the term "nanocrystalline" refers to a crystalline microstructure having a grain size of 5-1,000 nm, preferably 10-100 nm.

The term "single crystal" refers to a tantalum film characterized by an absence of large-angle crystal boundaries and by a regular atomic structural arrangement. As used herein, the term "single crystal" includes material without large-angle boundaries but may contain dislocations, twins and stacking faults. The term also includes superlattice, epitaxy, oriented-crystals, or enlarged crystals (when the enlarged crystals are used as though they are a single-crystal or when the enlarged crystals are used individually as single-crystals).

Numerous methods of metallic film deposition are known in the art. Such methods include, for example, chemical vapor deposition, thermal evaporation, (accelerated) molecular beam epitaxy (MBE), atomic-layer deposition (ALD), cathodic arc, laser assisted, metal organic, plasma enhanced, sputtering methods such as RF, magnetron or ion beam sputtering, ion beam deposition and pulsed laser deposition. Any of the above listed methods can be used to deposit the tantalum films of the present invention by scaling the relevant deposition and substrate variables.

Accordingly, in some aspects the present invention provides α-tantalum films having a nanocrystalline microstructure, as characterized by broad x-ray diffraction peaks at 2θ = 38, 55 and 69 degrees and continuous electron diffraction rings. The present invention also provides in some embodiments α-tantalum films having a single crystal microstructure as characterized by an x-ray diffraction peak at 2θ = 55° (200) and characteristic spot electron diffraction pattern, corresponding to a lattice constant of 0.33 nm. The single crystal tantalum film has been found (see example below) to have a resistivity of between 15-30 µΩcm.

The nanocrystalline α-tantalum films have higher resistivity in the range of 30-50 µΩcm, where the resistivity increases as grain size decreases. The films are usually between 5-1,000 nm in thickness, sometimes 10-100 nm thick, although the thickness will vary depending on the particular device in which it is used, as will be understood by one skilled in the art.

In an additional aspect, the present invention provides a tantalum film having an amorphous microstructure as characterized by a diffuse x-ray diffraction peak at 2θ= 30-35° and a diffuse ring in the electron diffraction pattern.

As described in the example, the amorphous film has been found to have a resistance of 250-275 µΩcm. All three films (single crystal, nanocrystalline and amorphous) have been found to have net diffusion distance of less than 10 nm after annealing with copper at a temperature between 650-750°C for 1 hour.

While previously hypothesized to exist, the nanocrystalline, single crystal and amorphous tantalum films have never before been proven with analytical methods such as x-ray diffraction. All three films can be deposited without the need for a seed layer such as Ta (N), Ta₂O₅, or other types of material.

In an additional aspect, the present invention provides methods of forming tantalum films on a substrate. The method comprises providing a substrate ; optionally, preheating the substrate; providing a vacuum chamber with an operating pressure of 10-⁴ -10-¹⁰ ; and depositing the tantalum film on the substrate in the vacuum chamber by a method selected from the group consisting of chemical vapor deposition, thermal evaporation, (accelerated) molecular beam epitaxy (MBE), atomic-layer deposition (ALD), cathodic arc, laser assisted, metal organic, plasma enhanced, sputtering, ion beam deposition and pulsed laser deposition (PLD). Deposition parameters, such as average energy of species, energy density, pulse duration and wavelength, in the case of pulsed laser deposition, for example, are adjusted to the appropriate settings (as described more fully below) to achieve the desired microstructure. Similarly, chamber and/or substrate parameters (such as temperature, ambient air and vacuum properties) are also adjusted to provide the desired microstructure. One skilled in the art can adapt the method to the various deposition means by scaling the parameters for the particular method to be used.

Any suitable substrate can be used, depending on the needs of the user and the article being fabricated. Suitable substrates include, but are not limited to, polymeric materials, metals, ceramics, fiber-reinforced materials, and combinations of any of these. Preferred in the fabrication of microelectronic devices is the use of a silicon substrate.

In one aspect, the operating pressure of the vacuum chamber is between 10⁻⁴ -10⁻¹⁰ Torr. In some embodiments such as the amorphous microstructured film, the operating pressure is preferably 10⁻⁵ -10⁻⁷ Torr. In other embodiments such as in the single crystal and nanocrystalline microstructured films, the operating pressure is preferably 10⁻⁷ -10⁻¹⁰ Torr

In some aspects, the substrate is preheated to a temperature of 100°C to 200°C, or to a temperature of 130-170°C and the resulting tantalum film has a nanocrystalline microstructure. In other aspects, the substrate is epitaxially grown as described in my US Patent 5,406, 123. The substrate is preheated to a temperature of 600°C to 750°C, sometimes 630-670°C, prior to deposition. The tantalum film is deposited by planar matching as described in US 5,406, 123, and the resulting tantalum film has a single crystal microstructure. Both nanocrystalline and single crystal tantalum films can be deposited, for example, using pulsed laser deposition, as is known in the art. For amorphous tantalum films, it is not required that the substrate be preheated, and the substrate temperature can range anywhere from room (ambient) temperature (21°C) up to a temperature of 750°C.

When the method of deposition is pulsed laser deposition the following parameter are adjusted: energy density of 2-5 joules/cm², sometimes 3-4 joules/cm²; pulse duration 10-60 nanoseconds, sometimes 15-30; wavelength 193-308 nanometers with specific values 193, 248 and 308 nanometers; repetition rate 5-10 Herz. These parameter values can also be used when the molecular beam epitaxy method of deposition is used.

In an additional aspect, oxygen can be introduced into the vacuum chamber to produce oxygen-doped amorphous tantalum films. However, the method of the present invention can produce amorphous tantalum films without introducing oxygen into the chamber, the films having an oxygen impurity below the detection limit, less than 0.1 atomic %.

The present invention also provides articles such as a microelectronic (integrated circuits), magnetic, optical (light emitting diodes) devices, where diffusion barriers are required to preserve chemical composition and microstructure and hence retain useful properties of devices during their operation.

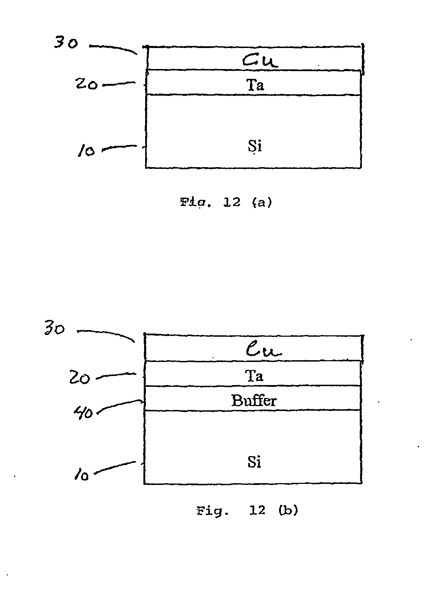

The tantalum film can have an amorphous, nanocrystalline or single crystal microstructure. Figures 12 (a) and 12 (b) show cross-sectional views of a microelectronic device such as an LED having a silicon substrate **10** a tantalum layer **20** and a copper layer **30** (in 12 (b) ) and without (in 12 (a) ) a butter layer **40.** Methods of copper deposition in microelectronic devices are well known in the art. The buffer layer can be used with a tantalum film having any of the above-described microstructures. In other embodiments, the microdevice can have a substrate other than silicon, such as a substrate made out of a polymeric material.

Considering the above particularly preferred embodiments of the present invention are:
- Paragraph 1:: A tantalum film having a nanocrystalline microstructure as characterized by a broad x-ray diffraction peak at 2θ = 38° and continuous electron diffraction rings.
- Paragraph 2:: The tantalum film of paragraph 1 wherein the tantalum is α-tantalum.
- Paragraph 3:: The tantalum film of paragraph 1having a resistance of 30-50 µΩcm.
- Paragraph 4:: The tantalum film of paragraph 1 having a net diffusion distance of less than 10 nm after annealing with copper at a temperature between 650-750°C for 1 hour.
- Paragraph 5:: A tantalum film having a single crystal microstructure as characterized by an x-ray diffraction peak at 2θ = 55° and characteristic (100) spot diffraction pattern.
- Paragraph 6:: The tantalum film of paragraph 5, wherein the tantalum is α-tantalum.
- Paragraph 7:: The tantalum film of paragraph 5, having a resistance of 15-30 µΩcm.
- Paragraph 8:: The tantalum film of paragraph 5, having a net diffusion distance of less than 10 nm after annealing with copper at a temperature between 650-750°C for 1 hour.
- Paragraph 9:: A tantalum film having an amorphous microstructure as characterized by a diffuse x-ray diffraction peak at 2θ = 30 - 35° and a diffuse ring in the electron diffraction pattern.

- Paragraph 10:: The tantalum film of paragraph 9, having a resistance of 250-275 µΩcm.
- Paragraph 11:: The tantalum film of paragraph 9, having a net diffusion distance of less than 10 nm after annealing with copper at a temperature between 650-750°C for 1 hour.
- Paragraph 12:: A method of forming a tantalum film comprising: providing a substrate; optionally, preheating the substrate; providing a vacuum chamber; adjusting the deposition parameters, chamber and substrate parameters as necessary to achieve the desired microstructure; and depositing the tantalum film on the substrate in the vacuum chamber at an operating pressure of 10⁻⁴-10⁻¹⁰ by a method selected from the group consisting of chemical vapor deposition, thermal evaporation, (accelerated) molecular beam epitaxy, atomic-layer deposition, cathodic arc, laser assisted, metal organic, plasma enhanced, sputtering, ion beam deposition and pulsed laser deposition.
- Paragraph 13:: The method of paragraph 12, wherein the operating pressure is between 10⁻⁵-10⁻¹⁰ Torr.
- Paragraph 14:: The method of paragraph 12, wherein the method is pulsed laser deposition or molecular beam epitaxy and the laser is adjusted to an energy density of 2-5 joules/cm².
- Paragraph 15:: The method of paragraph 14, wherein said deposition parameter is pulse duration and is adjusted to 10-60 nanoseconds.
- Paragraph 16:: The method of paragraph 14, wherein said deposition parameter is wavelength and is adjusted to 193 nm to 308 nm.
- Paragraph 17:: The method of paragraph 12, wherein the substrate is preheated to a temperature of between 100°C to 200°C and tantalum film has a nanocrystalline microstructure.

- Paragraph 18:: The method of paragraph 17, wherein the operating pressure of the vacuum chamber is 10⁻⁷-10⁻¹⁰ Torr.
- Paragraph 19:: The method of paragraph 12, wherein the substrate is epitaxially grown and is preheated to a temperature of 600°C to 750°C and the tantalum film has a single crystal microstructure.
- Paragraph 20:: The method of paragraph 19, wherein the operating pressure of the vacuum chamber is 10⁻⁷-10⁻¹⁰ Torr.
- Paragraph 21:: The method of paragraph 12, wherein the substrate is 20-30°C during deposition and the tantalum film has an amorphous microstructure.
- Paragraph 22:: The method of paragraph 21, wherein the operating pressure is 10⁻⁵- 10⁻⁷ Torr.
- Paragraph 23:: A microelectronic device having a silicon substrate, a tantalum film deposited on the silicon substrate and a copper layer disposed on the tantalum film, wherein the tantalum film has an amorphous microstructure.
- Paragraph 24:: A microelectronic device having a silicon substrate, a tantalum film deposited on the silicon substrate and a copper layer disposed on the tantalum film, wherein the tantalum film has a nanocrystalline microstructure.
- Paragraph 25:: A microelectronic device having a silicon substrate, a tantalum film deposited on the silicon substrate, and a copper layer disposed on the tantalum film, wherein the tantalum film has a single crystal microstructure.
- Paragraph 26:: The device of paragraph 25, wherein the device has a buffer layer of TiN or TaN deposited between the silicon substrate and said tantalum film.
- Paragraph 27:: A method of depositing a tantalum film on a substrate comprising energizing the tantalum; depositing the tantalum on a substrate; and quenching the tantalum to kinetically trap the amorphous form at a temperature that formation of crystalline phase is suppressed.

- Paragraph 28:: The method of paragraph 27, wherein said temperature is 20-600°C.

### EXAMPLE

Scanning transmission electron microscopy-Z (STEM Z) contrast imaging provides contrast of elements based on differences in atomic number (Z² dependence). Electron energy-loss spectroscopy (EELS) allows compositional analysis by detecting the characteristic energy-loss of the electron of the particular element. Both of these methods provide powerful tools to determine the diffusion profile of Cu with a great precision (0.16 nm spatial resolution), as compared to SIMS profiles where resolution is of the order of 10 nm. Thus, using HRTEM, STEM-Z contrast imaging and EELS, atomic structure imaging and compositional analysis were obtained on α-Ta films with microstructures ranging from amorphous to single crystal, and the results compared with large-area SIMS studies.

Alpha tantalum (α-Ta) films with microstructures ranging from amorphous to nanocrystalline to polycrystalline to single crystal were formed on silicon (Si) substrates with and without buffer layers. Thin films of Alpha tantalum (α-Ta) with grain sizes ranging from nanosize to single crystal and amorphous tantalum were fabricated by non-equilibrium pulsed laser deposition techniques, and their electrical properties and diffusion characteristics were compared with properties of Beta tantalum (β-Ta) films produced by magnetron sputtering. Single-crystal α-Ta films are formed on silicon (Si) substrates with and without buffer layers by domain matching epitaxy (as described in US Patent 5,406, 123) where integral multiples of lattice planes match across the film-substrate interface. The buffer layers such as titanium nitride (TiN) and tantalum nitride (TaN) were used to provide a template for epitaxial growth of α-Ta. Microstructure and atomic structure of these films were studied by X-ray diffraction and high-resolution electron microscopy, while elemental analysis was performed using electron energy loss spectroscopy and X-ray dispersive analysis. The resistivity measurements in the temperature range (10-300°C) showed room-temperature values to be 15-30µΩcm for α-Ta, 180-200µΩcm for β-Ta and 250-275µΩcm for amorphous tantalum ("α-Ta"). The temperature coefficient of resistivity (TCR) for α-Ta and β-Ta were found to be positive with characteristic metallic behavior, while TCR for α-Ta was negative, characteristic of high-resistivity disordered metals. Amorphous tantalum is stable up to 650-700°C. Electron energy-loss spectroscopy (EELS) and Rutherford backscattering measurements showed oxygen content in α-Ta films to be less than 0.1 atomic%. The EELS and secondary ion mass spectroscopy (SIMS), scanning transmission electron microscope Z-contrast (STEM-Z) imaging and electron energy-loss spectroscopy (EELS) studies show that, after 650°C annealing for 1 hr, α-Ta and single-crystal α-Ta films have less than 10 nm Cu diffusion distance while polycrystalline Ta films have substantial Cu diffusion specifically along grain boundaries. Thus, α- Ta and single-crystal α-Ta provide a far superior diffusion barrier for Cu metallization compared to polycrystalline α-Ta and β-Ta films containing grain boundaries. The superior diffusion properties of α-Ta and single-crystal α-Ta, when combined with low-resistivity epitaxial layers of α-Ta, provide an optimum solution for copper metallization in next-generation silicon microelectronic devices.

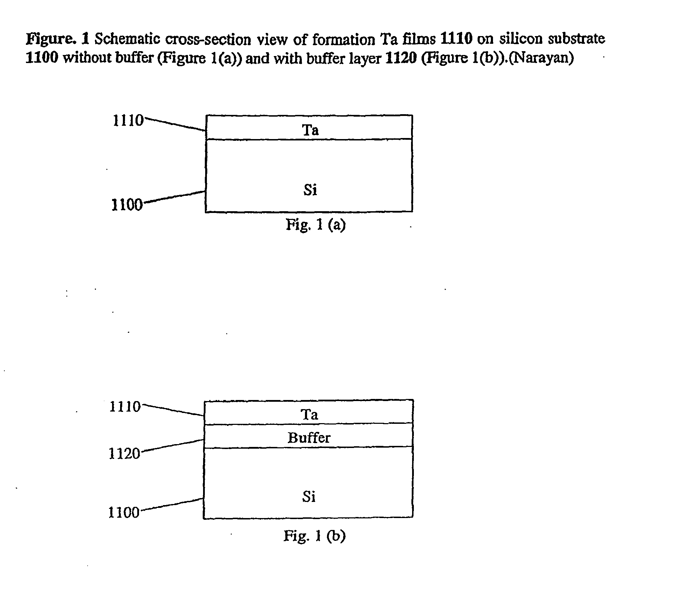

Figures 1(a) and 1(b) are cross-sectional views of microelectronic structures that may be fabricated according to some embodiments of the present invention. As shown in Figure 1(a), silicon substrate **10,** for example a (100) silicon substrate, is provided. Techniques for fabricating silicon substrates are well known to those skilled in the art and need not be described further herein.

Also shown in Figure 1 (a), α-Ta thin film **20** with amorphous, nanocrystalline, polycrystalline and single crystal structures of α (alpha) and β (beta) phases, is formed directly on the silicon substrate. In some embodiments, domain epitaxy (as described, for example, in U.S. Patent 5,406, 123) may be used to deposit single crystal Ta films directly on the silicon substrate **10.** As shown in Figure 1(b), in some embodiments, a buffer layer **40** is formed prior to growth of Ta **20.** These buffer layers (for example, TiN or TaN) may be grown in the form of single crystal which facilitate the formation of single crystal Ta films.

For some embodiments, Si (100) substrates were cleaned to remove the native oxide layer around 1. 5nm thick using HF solution, and create hydrogen- terminated (100) Si surfaces. Uniform films of Ta were deposited on Si (100) by Laser MBE (molecular beam epitaxy) for nano, polycrystal and single-crystal a- Ta films, pulsed laser deposition (PLD) for α-Ta, and by dc Magnetron Sputtering (MS) β-Ta.

For diffusion studies, in-situ deposition of uniform Cu layer on the Ta/Si (100) substrates was carried out using PLD. For PLD, the films were deposited inside a stainless-steel vacuum chamber evacuated by a turbo molecular pump to a base pressure of lux 10⁻⁷ Torr, where a KrF excimer laser (λ=248 nm, τ∼25ns) was used for the ablation of Ta and Cu targets. The hot pressed Ta and high purity Cu targets, mounted on a rotating target holder, were ablated at an energy density of 3.0-3.5 J/cm². Ta and Cu films were deposited at a laser repetition rate of 5-10Hz for 20 and 10 minutes achieving thickness of 50nm and 20nm, respectively.

For Laser-MBE, an ultra-high-vacuum chamber equipped with high-power KrF laser was used for forming layers, where the deposition parameters were as follows: base pressure ∼4x10⁻⁹ Torr, laser pulse rate of 5 to 10 Hz, laser radiation wavelength λ= 248 nm and pulse width 25-35nsec, laser pulse energy (exit port) of 600-800 mJ with energy density 3.0-4.0 J/cm². For dc magnetron-sputtering deposition Ar gas of 99.999% purity was used at a flow rate of 20 sccm during deposition. A hollow cathode electron source was used to sustain the discharge at 3x10⁻⁴ Torr (Ar) during deposition. Ta films of 90 nm thickness were deposited at 300W, which yields a deposition rate of about 50 nm/min.

The films were analyzed by X-ray diffraction using a Rigaku Diffractometer equipped with Cu-Ka source operating at a power as high as 5kW.

The RBS (Rutherford backscattering) measurements using 2.0 MeV α ions and EELS studies were made to estimate the oxygen content in the films. The nature of the microstructure in these films was studied using cross-section samples in a 200 keV JEOL 2010F high-resolution transmission electron microscope (HRTEM) with point-to-point resolution of 1.8Å.

These samples were annealed at a base pressure of 1x10⁻¹ Torr up to 700°C.

SIMS, STEM-Z contrast imaging and EELS with 0.16nm resolution were used to study Cu diffusion behaviors in Ta films with different microstructures. SIMS analysis was performed using CAMECA IMS-6f. A 10 keV, 200nA Cs⁺ primary ion beam was rastered over an area of 150x1SO, um2 with the mass resolution of 1600 m/Δm.

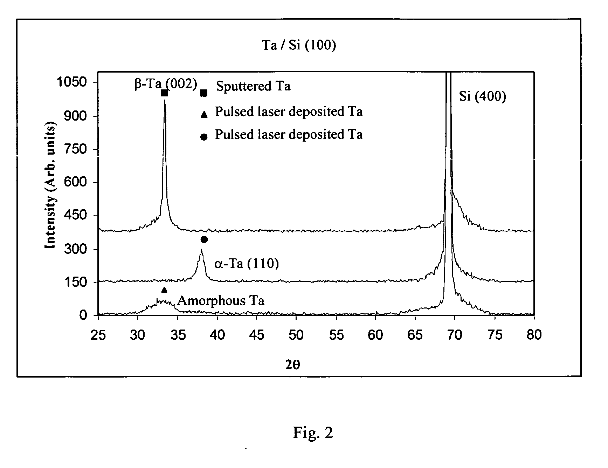

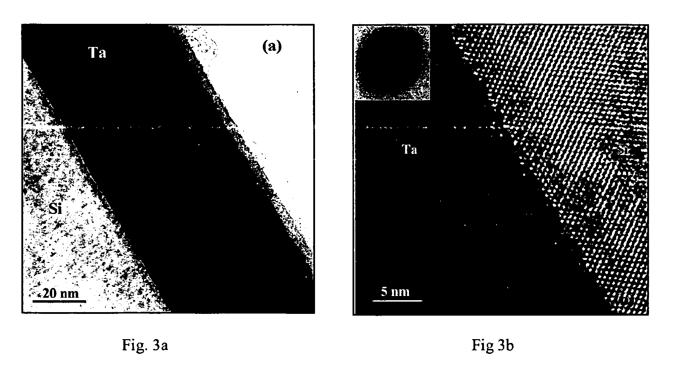

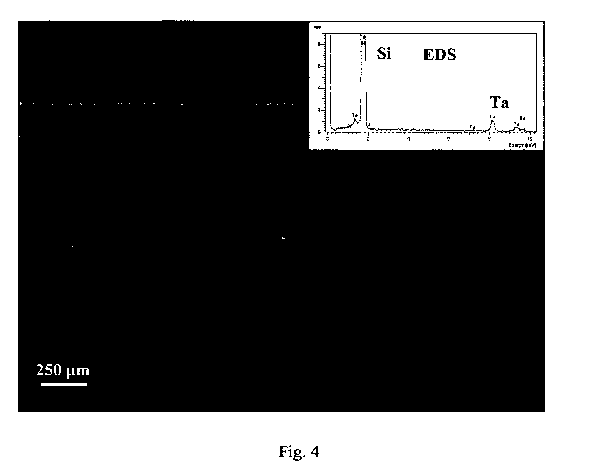

Fig. 2 shows the XRD pattern of the films deposited on Si (100) at room temperature by PLD, laser-MBE and DC magnetron sputtering. A sharp peak corresponding to polycrystalline (β-Ta (002) is observed for the film deposited by sputtering, a relatively weaker peak corresponding to α-Ta (110) for the film deposited by laser-MBE and a broad peak is observed for the film deposited by PLD. The broad peak indicates that the film deposited by PLD is amorphous. To confirm the amorphous structure of the Ta film deposited by PLD, a high- resolution TEM study was performed. Fig. 3 (a) is a low magnification cross- section image of the Ta/Si (100) interface which shows that the film thickness is ∼50 nm. Fig. 3 (b) is a high resolution image of the Ta/Si interface, where Ta film is seen to be amorphous and the structure of crystalline silicon substrate serves as a standard for the amorphous structure of the Ta film. The film structure is completely amorphous and no regions with any local ordering are observed. The selected area diffraction pattern (SAD) shown as an inset in fig. 3 (b) illustrates a diffused ring pattern, which is characteristic of the amorphous materials. The Ta/Si interface is fairly sharp and free of any visible oxide layer. Fig. 4 is a SEM micrograph of the Ta film deposited by PLD showing the surface morphology.

From the micrograph it can be observed that the film surface is smooth and free of any observable defects such as voids or porosity. Another notable observation is that even at high magnification no grains are revealed which also indicates that the film is amorphous. The EDS on the Ta film surface is shown as an inset in Fig. 4 and shows no indication of the presence of O or N in the film within its detection limit.

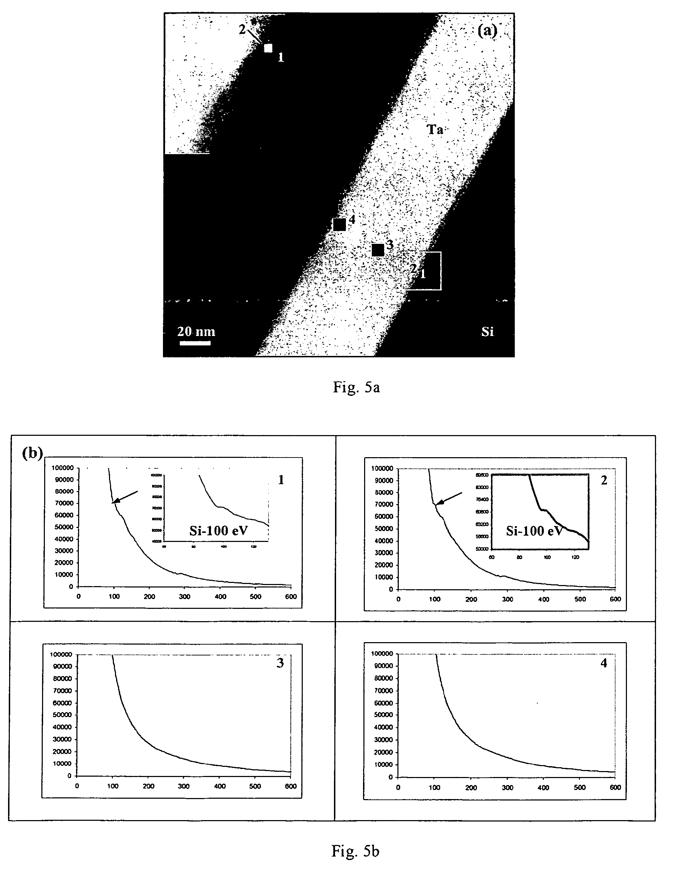

The oxygen content m the films was also investigated by EELS in high- resolution TEM and RBS (Rutherford backscattering) techniques. Fig. 5 (a) is a high magnification TEM image showing the various locations in the Ta film including the Ta/Si interface at which the EELS was carried out and Fig. 5 (b) shows the corresponding EELS spectra. From the EELS spectra it can be seen that the concentration of O and N at the interface and in the interior of the film is very low and cannot be detected by EELS. The only element detected inside the film was Si, about 1 nm from the interface. The RBS and channeling studies confirmed the presence of the amorphous tantalum structure as there was no difference between the random and aligned channeling yields. The random spectrum showed some indication of oxygen scattering with an estimated concentration of less than 0.1 atomic%.

To form amorphous films, material is energized, e. g. by melting, dissolution, or irradiation and then de-energized rapidly by bringing dissimilar surfaces together and further de-energized (such as by quenching) to kinetically trap the amorphous form at a temperature that formation of crystalline phase is suppressed. L. J. Chen, Mat. Sci. & Eng. R : Reports, (29) 5 Sept. 2000 (115). The mechanism of the formation of amorphous Ta during PLD is surmised to result from oxygen impurity, which reduces the mobility of Ta atoms on the substrate.

The Ta atoms are effectively quenched into their sites when oxygen atoms reduce their mobility. This reduction in mobility prevents the development of any long-range ordering needed for recrystallization of Ta films. This mechanism can be generalized by introducing relatively immobile impurities during deposition and it is possible to prevent the development of long-range ordering and render the structure amorphous.

The α-Ta films were formed by pulsed laser deposition under an ultra high vacuum <10⁻⁷ Torr conditions where oxygen impurity content was extremely small.

The films deposited at 25°C under these conditions showed a grain size of 10-20 nm, and the grain size increased with increasing substrate temperature. Epitaxial films were produced at temperatures of 650°C and higher. The epitaxial growth of α-Ta films was realized via domain matching epitaxy with TiN buffer layer where integral multiples (4/3) of lattice planes matched across the film-substrate interface J. Narayan et al. Appl. Phys. Lett. 61,1290 (1992); US Patent # 5,406, 123 (4/11/1995); J. Narayan and B. C. Larson, J. Appl. Phys. 93,278 (2003).

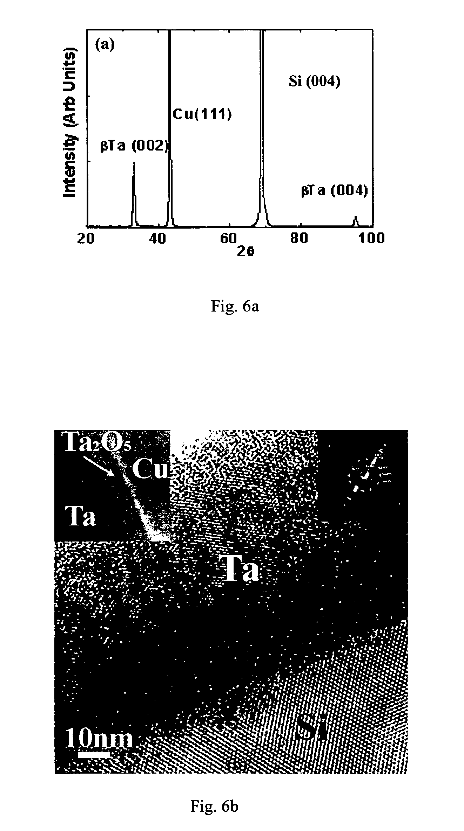

Films deposited by the dc-magnetron sputtering were predominantly (002) oriented β-Ta phase as shown by the X-ray diffraction pattern in figure 6 (a). The HRTEM image of β-Ta film in the figure 6 (b) along with the diffraction pattern in the insert shows the polycrystalline nature of the Ta film with the average grain size of around 30 nm. Ta layer is predominantly oriented in the (002) direction with its lines fringes parallel to the interface. Selected area electron diffraction patterns of a cross-section samples shows a strong orientational relationship between Cu (111) and Ta (002) aligned with Si (001). The alignment of Cu (111) with tetragonal symmetric β-Ta atoms requires pseudohexagonal atomic arrangement in the (002) β-Ta plane for the heteroepitaxial growth with the misfit strain 7.6 %. K. W. Kwon, C. Ryu, R. Sinclair, S. S. Wong, Appl. Phys. Lett. 71,3069 (1997).

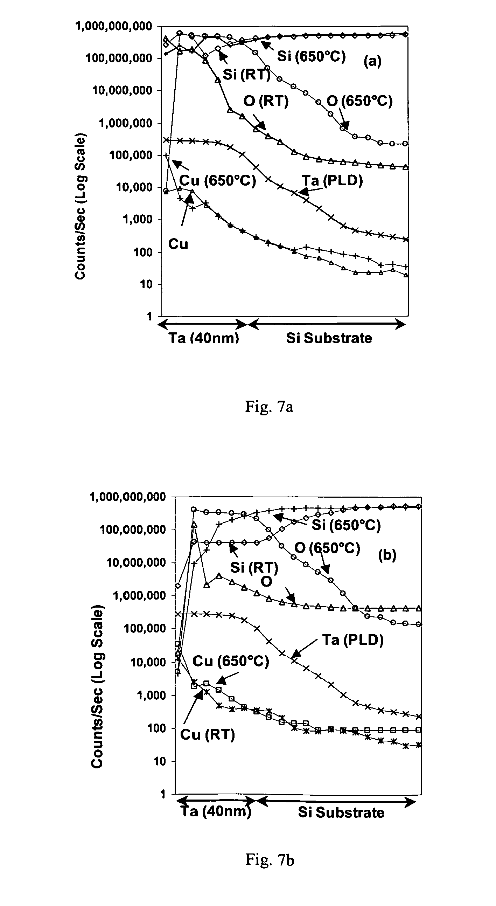

After attaining the amorphous and polycrystalline microstructures of Ta films, all the samples were annealed simultaneously at 650°C ±30°C for 1 Hr to compare the effect of microstructure on diffusion behavior of Cu. After annealing, the presence of undiffused Cu on Ta films could overshadow the signal from the diffused Cu in Ta films for the SIMS experiment. To overcome this, the Cu films on top of Ta films were removed with an etching agent consisting of (NH₄OH (20mL) ; H₂O₂ (20 mL), H₂O (10 mL)). SIMS profiles for Cu diffusion in amorphous Ta after annealing at 650°C ±30°C for 1 Hr are shown in the figure 7 (a) and compared with the unannealed samples as shown in the figure 7 (b).

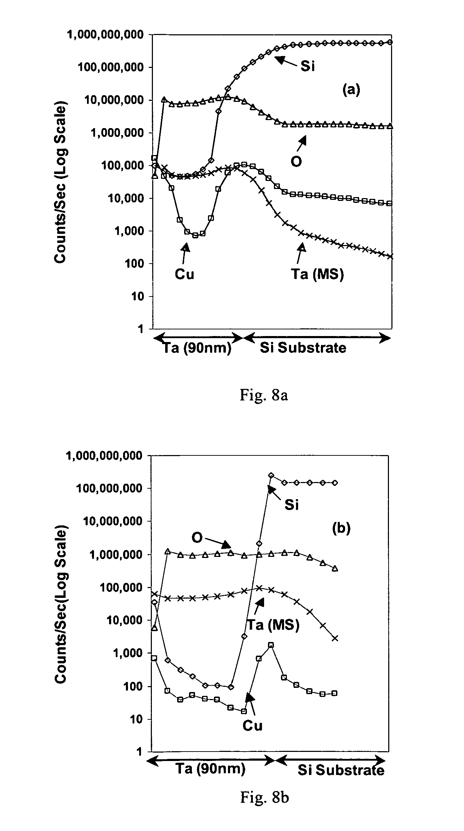

Amorphous films lack grain boundaries, which act as rapid diffusion paths to assist rapid diffusion and are more robust diffusion barrier. As can be seen in figure 7, there is an insignificant change (within the sensitivity of SIMS < 10 nm) in the profile of Cu in the amorphous Ta film for both annealed and unannealed samples and no Cu signal is observed inside the Si substrate, which points to insignificant diffusion of Cu into the amorphous Ta films. The presence of impurities like O rendering the amorphization of the Ta films by PLD and in diffusion of Si into the film can be seen in the SIMS profile for both annealed and un-annealed samples. Similarly, the SIMS profiles for the diffusion of Cu in poly crystalline la Mims for annealed and unannealed samples are shown in the figure 8 (a) and figure 8 (b), respectively. The pseudocolumnar growth of polycrystalline films containing grain boundaries, which connect the overlayers with the substrate, serve as fast diffusion paths for Cu. Significant diffusion of Cu in the annealed polycrystalline Ta films is observed as seen in the figures due to a significant increase in the Cu signal compared to the unannealed sample inside Ta films. Significant increase of Cu signal inside the Si substrate as compared to the unannealed samples also confirms the excessive diffusion of Cu in polycrystalline Ta films. The peaks in the SIMS profiles are observed due to the differences in the yield of Cu signal in Ta and Si matrices. Amorphous Ta films by PLD shows significantly less diffusion of Cu as compared to the polycrystalline Ta films.

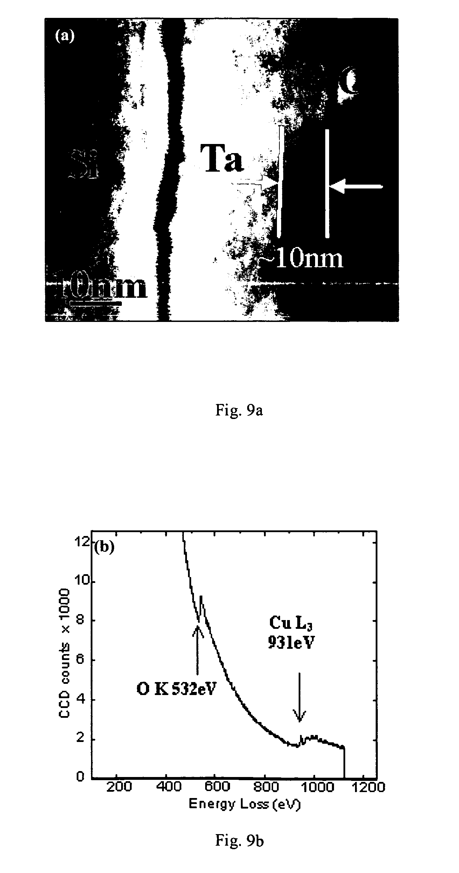

Diffusion in the amorphous Ta film was also studied with Z-contrast imaging and EELS, which provide chemical composition and information on bonding characteristics. S. Lopatin, S. J. Pennycook, J. Narayan, and G. Duscher, J. Appl. Phys. Lett. 81 2728 (2002). Figure 9 (a) shows the Z-Contrast image of CdTa (PLD 650°C)/Si sample annealed at 650°C for 1 Hr where the probe formed by the electron beam was scanned across the Ta films to detect the Cu signal with EELS as shown in Fig. 9 (b), where the Cu-L₃ edge onset corresponds to 931eV. The total diffusion length of the annealed amorphous sample is around 10 nm. Similar diffusion studies done for the single crystal sodium chloride structure TaN films by similar STEM imaging technique showed similar diffusion length of ∼10 nm for the given temperature and time. H. Wang, A. Tiwari, X. Zhang, A. Kvit, and J. Narayan, J. Appl. Phys. Lett. 81,1453 (2002). From a structural perspective, TaNₓ phases, which can be described as close-packed arrangements of Ta atoms with smaller N atoms inserted into interstitial sites, have significantly higher resistance to Cu diffusion than does the pure Ta metal.

However, amorphous Ta films deposited by PLD lack interstitial sites and are as effective diffusion barriers as single crystal TaN films. Hence Ta films deposited by PLD can eliminate the issues of using different precursors and techniques to achieve stoichiometric TaN and the variability in the resistivity behavior of various TaNₓ phases can be avoided. H. Kim, A. J. Kellock, and S. M. Rossnagel, J. Appl. Phys., 92 (12), 7080 (2002).

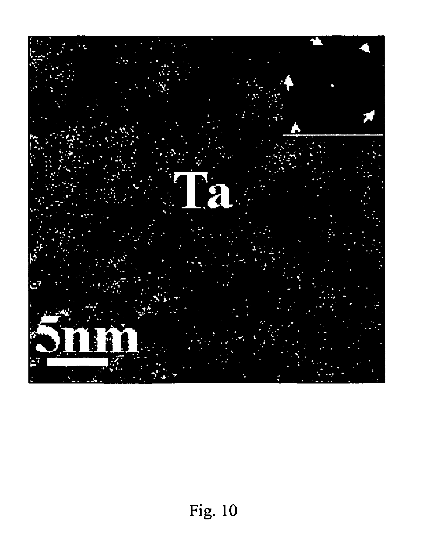

The amorphous nature of the Ta film was found to be stable up to 700°C, above which the films starts to recrystallize as shown in the HRTEM image of annealed Ta film in Figure 10. SIMS experiments at this temperature for both amorphous and polycrystalline Ta films showed significant diffusion of Cu in Ta film and Si substrate due to grain boundary diffusion. The single-crystal Ta films, on the other hand, were found to be extremely stable with temperatures over 800°C and no significant diffusion of copper into single-crystal Ta films was observed.

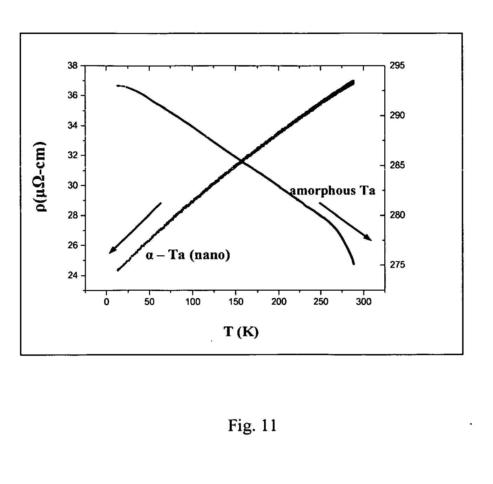

To lower the RC delay in the integrated circuits for future generation devices barrier layers also play a significant role in governing the resistivity of interconnects. The microstructures of the barrier layers play an important role in the resistivity behavior of the films. Figure 11 shows the resistivity behavior in the temperature range of 12-300°C of the amorphous film grown by PLD and of polycrystalline film grown by the MS. The amorphous films exhibit negative temperature coefficient of resistivity (TCR) values whereas polycrystalline films show positive TCR behavior. Similar transitions in the TCR behavior from negative to positive have been observed previously, P. Catania, R. A. Roy, and J. J. Cuomo, J. Appl. Phys. 74 (2), 15 July (1993), which can be attributed to change in the crystal structure. The negative TCR behavior in amorphous film is due to the weak localization and enhanced electron-electron interaction in the system which have been observed in several other metals and alloys. M. A. Howson, D. Greig, Phys. Rev B, 30,4805 (1984). As compared to pure β-Ta with resistivity of ∼220µΩcm, H. Kim, A. J. Kellock, and S. M. Rossnagel, J. Appl. Phys., 92 (12), 7080 (2002), the resistivity values of amorphous Ta films produced by laser ablation is in the range of ∼275µΩcm at room temperature and decreases at higher temperature due to its negative TCR behavior to satisfy the constraints of delays in interconnects. The room-temperature resistivity of α-Ta was determined to vary between 15-30 µΩcm as the microstructure changed from single-crystal to nanocrystalline materials.

Amorphous, nanocrystalline, polycrystalline and single-crystal Ta films were produced by pulsed laser deposition and dc magnetron sputtering techniques.

X-ray diffraction and high-resolution transmission electron microscopy techniques confirm the microstructure of these films. The formation of amorphous Ta is linked to trace amount of oxygen introduced during deposition. The oxygen atoms trap Ta atoms locally and prevent the structure from establishing a long- range order. Single-crystal Ta films on silicon were stable with temperature over 800°C, while amorphous Ta films recrystallized at 700°C and above. The resistivity measurements in the temperature range (10-300°C) showed room- temperature values to be 15-30 Ωµcm for α-Ta, 180-200 µΩcm for β-Ta and 250-275 µΩcm for α-Ta. The temperature coefficient of resistivity (TCR) for α- Ta and β-Ta were found to be positive with characteristic metallic behavior, while TCR for α-Ta was negative characteristic of high-resistivity disordered metals.

The diffusion characteristics of Cu/Ta/Si layers showed amorphous Ta and single-crystal Ta to be a far superior diffusion barrier than polycrystalline Ta films where grain boundaries provided rapid diffusion paths for copper. However, amorphous structure lost its superior diffusion properties after recrystallization at 700°C.

Thus, single crystal and amorphous Ta films combined with low-resistivity of α- Ta provide an excellent solution for Cu diffusion problem in next-generation silicon microelectronic devices.

Considering the above description, particularly preferred embodiments of the present invention are:
- Paragraph 1:: A tantalum film having a nanocrystalline microstructure as characterized by a broad x-ray diffraction peak at 2θ=38° and continuous electron diffraction rings.
- Paragraph 2:: The tantalum film of paragraph 1 wherein the tantalum is α-tantalum.
- Paragraph 3:: The tantalum film of paragraph 1having a resistance of 30-50 µΩcm.
- Paragraph 4:: The tantalum film of paragraph 1 having a net diffusion distance of less than 10 nm after annealing with copper at a temperature between 650-750°C for 1 hour.
- Paragraph 5:: A tantalum film having a single crystal microstructure as characterized by an x-ray diffraction peak at 2θ= 55° and characteristic (100) spot diffraction pattern.
- Paragraph 6:: The tantalum film of paragraph 5, wherein the tantalum is α-tantalum.
- Paragraph 7:: The tantalum film of paragraph 5, having a resistance of 15-30 µΩcm.
- Paragraph 8:: The tantalum film of paragraph 5, having a net diffusion distance of less than 10 nm after annealing with copper at a temperature between 650-750°C for 1 hour.
- Paragraph 9:: A tantalum film having an amorphous microstructure as characterized by a diffuse x-ray diffraction peak at 2θ= 30-35° and a diffuse ring in the electron diffraction pattern.
- Paragraph 10:: The tantalum film of paragraph 9, having a resistance of 250-275 µΩcm.
- Paragraph 11:: The tantalum film of paragraph 9, having a net diffusion distance of less than 10 nm after annealing with copper at a temperature between 650-750°C for 1 hour.
- Paragraph 12:: A method of forming a tantalum film comprising: providing a substrate; optionally, preheating the substrate;

- Paragraph 13:: providing a vacuum chamber; adjusting the deposition parameters, chamber and substrate parameters as necessary to achieve the desired microstructure; and depositing the tantalum film on the substrate in the vacuum chamber at an operating pressure of 10⁻⁴-10⁻¹⁰by a method selected from the group consisting of chemical vapor deposition, thermal evaporation, (accelerated) molecular beam epitaxy, atomic-layer deposition, cathodic arc, laser assisted, metal organic, plasma enhanced, sputtering, ion beam deposition and pulsed laser deposition. The method of paragraph 12, wherein the operating pressure is between 10⁻⁵-10⁻¹⁰ Torr.
- Paragraph 14:: The method of paragraph 12, wherein the method is pulsed laser deposition or molecular beam epitaxy and the laser is adjusted to an energy density of 2-5 joules/cm².
- Paragraph 15:: The method of paragraph 14, wherein said deposition parameter is pulse duration and is adjusted to 10-60 nanoseconds.
- Paragraph 16:: The method of paragraph 14, wherein said deposition parameter is wavelength and is adjusted to 193 nm to 308 nm.
- Paragraph 17:: The method of paragraph 12, wherein the substrate is preheated to a temperature of between 100°C to 200°C and tantalum film has a nanocrystalline microstructure.
- Paragraph 18:: The method of paragraph 17, wherein the operating pressure of the vacuum chamber is 10⁻⁷-10⁻¹⁰ Torr.
- Paragraph 19:: The method of paragraph 12, wherein the substrate is epitaxially grown and is preheated to a temperature of 600°C to 750°C and the tantalum film has a single crystal microstructure.
- Paragraph 20:: The method of paragraph 19, wherein the operating pressure of the vacuum chamber is 10⁻⁷-10⁻¹⁰ Torr.
- Paragraph 21:: The method of paragraph 12, wherein the substrate is 20-30°C during deposition and the tantalum film has an amorphous microstructure.

- Paragraph 22:: The method of paragraph 21, wherein the operating pressure is 10⁻⁵- 10⁻⁷ Torr.
- Paragraph 23:: A microelectronic device having a silicon substrate, a tantalum film deposited on the silicon substrate and a copper layer disposed on the tantalum film, wherein the tantalum film has an amorphous microstructure.
- Paragraph 24:: A microelectronic device having a silicon substrate, a tantalum film deposited on the silicon substrate and a copper layer disposed on the tantalum film, wherein the tantalum film has a nanocrystalline microstructure.
- Paragraph 25:: A microelectronic device having a silicon substrate, a tantalum film deposited on the silicon substrate, and a copper layer disposed on the tantalum film, wherein the tantalum film has a single crystal microstructure.
- Paragraph 26:: The device of paragraph 25, wherein the device has a buffer layer of TiN or TaN deposited between the silicon substrate and said tantalum film.
- Paragraph 27:: A method of depositing a tantalum film on a substrate comprising energizing the tantalum; depositing the tantalum on a substrate; and quenching the tantalum to kinetically trap the amorphous form at a temperature that formation of crystalline phase is suppressed.
- Paragraph 28:: The method of paragraph 27, wherein said temperature is 20-600°C.

## Claims

1. A tantalum film having an amorphous microstructure **characterized by** a diffuse x-ray diffraction peak at 2θ = 30-35° and a diffuse ring in the electron diffraction pattern and having no grain boundaries.

2. The tantalum film of Claim 1, having a resistance of 250-275 µΩcm.

3. The tantalum film of Claim 1, having a net diffusion distance of less than 10 nm after annealing with copper at a temperature between 650-750°C for 1 hour.

4. A method of forming a tantalum film according to claim 1comprising:
providing a substrate;
optionally, preheating the substrate;
providing a vacuum chamber;
adjusting the deposition parameters, chamber and substrate parameters as necessary to achieve the desired microstructure; and
depositing the tantalum film on the substrate in the vacuum chamber at an operating pressure of 10⁻⁴ -10⁻¹⁰ by a method selected from the group consisting of chemical vapor deposition, thermal evaporation, (accelerated) molecular beam epitaxy, atomic-layer deposition, cathodic arc, laser assisted, metal organic, plasma enhanced, sputtering, ion beam deposition and pulsed laser deposition.

5. The method of Claim 4, wherein the operating pressure is between 10⁻⁵-10⁻¹⁰ Torr.

6. The method of Claim 4, wherein the method is pulsed laser deposition or molecular beam epitaxy and the laser is adjusted to an energy density of 2-5 joules/cm².

7. The method of Claim 6, wherein said deposition parameter is pulse duration and is adjusted to 10-60 nanoseconds.

8. The method of Claim 6, wherein said deposition parameter is wavelength and is adjusted to 193 to 308 nm.

9. The method of Claim 4, wherein the substrate is 20-30°C during deposition.

10. The method of Claim 9, wherein the operating pressure is 10⁻⁵-10⁻⁷ Torr.

11. A microelectronic device having a silicon substrate, a tantalum film according to claim 1 deposited on the silicon substrate and a copper layer disposed on the tantalum film.

12. A method of depositing a tantalum film on a substrate comprising:
energizing the tantalum;
depositing the tantalum on a substrate; and
quenching the tantalum to kinetically trap the amorphous form at a temperature that formation of crystalline phase is suppressed.

13. The method of Claim 12, wherein said temperature is 20-600°C.
